# EUROPEAN PATENT APPLICATION

(11) **EP 2 239 786 A1**
(43) Date of publication of application: **13.10.2010**
(21) Application number: 09005252.3
(22) Date of filing: 09.04.2009
(51) Int. Cl.: H01L 31/055, H01L 31/18, H01L 31/0336, H01L 31/072, H01L 31/032

(54) **High efficiency photovoltaic device, photovoltaic panel and manufacturing method thereof**

(71) Applicant: Von Roll Solar AG, 4226 Breitenbach (CH)
(72) Inventor: Wiese, Klaus, 73489 Jagstzell (DE); Tausch, Andreas, 39291 Hohenwarthe (DE); Schwinge, Erik-Folke, 80538 München (DE)
(74) Representative: HOFFMANN EITLE

(57) **Abstract**

The present invention relates to a photovoltaic device, in particular thin layer photovoltaic device, comprising a first transparent electrode, a first semiconductor layer comprising particles of a first semiconductor material, a second semiconductor layer comprising particles of a second semiconductor material, and a second electrode, wherein the first and the second semiconductor material are different materials, and wherein the particles of the first and the second semiconductor material have an average grain size in the range of 0.1-20 µm, preferably 1-10 µm, as well as to photovoltaic panels comprising two or more of such photovoltaic devices.

## Description

### FIELD OF THE INVENTION

The present invention relates to photovoltaic devices, in particular thin layer photovoltaic devices, comprising two semiconductor layers including micron sized particles of different materials, in particular specific combinations of inorganic materials. According to a further aspect, the present invention relates to photovoltaic panels comprising, connected in series, at least two of the photovoltaic devices. Moreover, the present invention is concerned with methods of manufacturing the photovoltaic devices, such as by printing, and to the use of mixtures comprising a binder and micron sized semiconductor particles in the manufacture of photovoltaic devices.

### BACKGROUND ART

To be competitive with conventional, such a fossil and nuclear energy sources, photovoltaic devices, also commonly referred to as solar cells, have to meet stringent requirements. So far, none of the photovoltaic described in the literature or available on the marked has obviously satisfied all of these requirements. For instance, organic photovoltaic devices suffer from significant degradation with time, and cannot be used at high temperatures which are typical in regions where sunlight is abundant, such as in deserts. For the production of inorganic photovoltaic devices, deposition methods such as CVD and recently MOCVD have been used. US 4, 612,411 is a case in point. Nanoparticles and nanocrystals have attracted attention as alternative photoactive materials in photovoltaic devices (see for instance US 2006/0062902 and WO 2007/065039), but the reproducibility of the performance of the photovoltaic cells left room for improvement. Generally the efficiency of the solar cells left much to be desired.

In view of the above, there was a high demand for photovoltaic devices that show reproducibly higher efficiency and reduced degradation over the systems of the prior art.

### SUMMARY OF THE INVENTION

The above objects can be attained by a photovoltaic device comprising a first transparent electrode, a first semiconductor layer comprising particles of a first semiconductor material, a second semiconductor layer comprising particles of a second semiconductor material, and a second electrode, wherein the first and the second semiconductor material are different materials, and wherein the particles of the first and the second semiconductor material have an average grain size in the range of 0.1-20 µm, preferably 1-10 µm.

The above photovoltaic devices proved to be excellent in their efficiency, and showed remarkable performance even at low of diffuse light. Moreover, as it turned out, they exhibit high degradation stability and can be used in a broad temperature range such as -40 to +100 °C.

According to another aspect, the present invention is concerned with methods of manufacturing the above photovoltaic devices, comprising applying at least the semiconductor layers, preferably all layers by printing, spray coating or spin coating, preferably by screen printing. Also, ink jet printing may be used.

Also the present invention deals with photovoltaic panels comprising two or more of the above photovoltaic devices that are connected in series.

Finally, the present invention relates to the use of a mixture comprising a binder and semiconductor particles having a grain size in the range of 1 to 10 µm in the manufacture of photovoltaic devices.

Preferred embodiments of the present invention are subject of the dependent claims.

### BRIEF DESCRIPTION OF THE DRAWINGS

Fig. 1 shows a sectional view of the basic construction of a photovoltaic device in accordance with the present invention.
Fig. 2 shows a sectional view of a concrete embodiment of the photovoltaic device of the present invention.
Fig. 3 shows a sectional view of a sealed photovoltaic device in accordance with the present invention.
Fig. 4 shows a sectional view of another concrete embodiment of the photovoltaic device of the present invention, which has three semiconductor layers.

### DETAILED DESCRIPTION OF THE INVENTION

As meant herein, the "photovoltaic device", which is commonly often referred to as a solar cell, can generate electricity when being irradiated with light. In a basic arrangement, the photovoltaic device comprises a first electrode, a first semiconductor layer, a second semiconductor layer and a second transparent electrode. The first semiconductor layer comprises particles of a first semiconductor material, and the second semiconductor layer comprises particles of a second semiconductor material. Thereby, the first and the second semiconductor materials are different materials. Moreover, the particles of the first and the second semiconductor material have an average grain size in the range of 0.1 to 20 µm, preferably in the range of 1 to 10 µm.

According to a preferred embodiment, the first and second semiconductor material is each an inorganic semiconductor material. Also, the first and the second semiconductor layers are preferably adjacent layers. The second semiconductor layer can also be referred to as a photoactive or active layer.

Turning to the materials of the semiconductor layers, in a preferred embodiment, the second semiconductor material is a group II-VI, group I-III-IV, group III-V, or group IV semiconductor. The group IV semiconductor may for instance be Si (silicon), such as p-doped Si. According to a particularly preferred embodiment, the second semiconductor material is selected from the group consisting of CuInGaSe₂, CuInSe₂, GaAs, CdTe, indium gallium nitride, silicon and mixtures thereof, especially CuInGaSe₂, CdTe, and/or Si (such as p-doped Si).

The first semiconductor material may serve to shift the wavelength of the irradiated light to the range of absorption of the second semiconductor layer. To accomplish this, the first semiconductor material may be a doped material selected from the group consisting of doped ZnS, doped CdS, doped ZnO, or doped Y₂O₃, preferably doped ZnS or doped CdS, and the dopant is preferably selected from the group consisting of Cu, Mn, Ag and In. The doping favours the shift in wavelength as indicated above. In practice, printing pastes comprising luminescent inorganic materials can be used for applying, in particular printing, the first semiconductor layer.

In the first and the second semiconductor layer, particles of several types of semiconductor material particles may be present. Thereby, the feature of Claim 1 of the first and the second semiconductor material being different is satisfied when at least one of the types of semiconductor material included in the first semiconductor layer, and at least one type of semiconductor material present in the second semiconductor layer is different. According to a preferred embodiment, none of the several types of first semiconductor material present in the first semiconductor layer is present in the second semiconductor layer, and vice versa.

For instance, as different types of semiconductor material in the first semiconductor layer, ZnS particles that are doped differently, especially within the group of dopants selected from the group consisting of Cu, Mn, Ag and In, proved to be beneficial. As a particularly preferred embodiment of a first semiconductor layer comprising particles of different types of semiconductor material, Mn-doped ZnS particles and Cu-doped ZnS particles at arbitrary mixing ratios can be mentioned.

In the photovoltaic device of the present invention, the first electrode and the second transparent electrode may be provided in the form of a pattern. According to a preferred embodiment, the first electrode and the second transparent electrode are independently layers. As used herein, the term "layer" is intended to imply a continuous coverage of the underlying layer(s).

In the photovoltaic device of the present invention as recited in Claim 1, the particles of the first and the second semiconductor material are defined inter alia by way of their average grain size. Herein, the average grain size of particles refers to the so-called d(0.5) value assuming a Gaussian distribution of the particles. As meant herein, the average grain size of particles can be measured by the laser diffraction spectrometry. For instance, a Mastersizer S V2.15 (of the company Malvern) can be used, preferably after dispersing the particles in a suitable inert liquid. For instance, a mixture of heptane and lecithin , in particular a mixture prepared by adding one drop of lecithin to two litres of heptane, proved to be useful for the measurement of the average grain size of the particles in accordance with the present invention. Herein, the particles of the semiconductor materials will occasionally be referred to as "pigment".

According to a preferred embodiment of the photovoltaic device of the invention, the first semiconductor material is ZnS doped with Cu and Mn, or with Ag, and the second semiconductor material is CuInGaSe₂ or Si (such as p-doped Si). When the first semiconductor material is ZnS doped with Cu and Mn, a blend of Cu-doped and Mn-doped ZnS particles as described above is particularly preferred.

According to another preferred embodiment, the first semiconductor material is CdS doped with Cu and Mn, with Ag, or with In, and the second semiconductor material is CdTe doped with Cl. According to a particularly preferred embodiment, the doped CdS particles have an average grain size of 1 to 7 µm, and the doped CdTe particles have an average grain size in the range of 1-5 µm, preferably 3-5 µm.

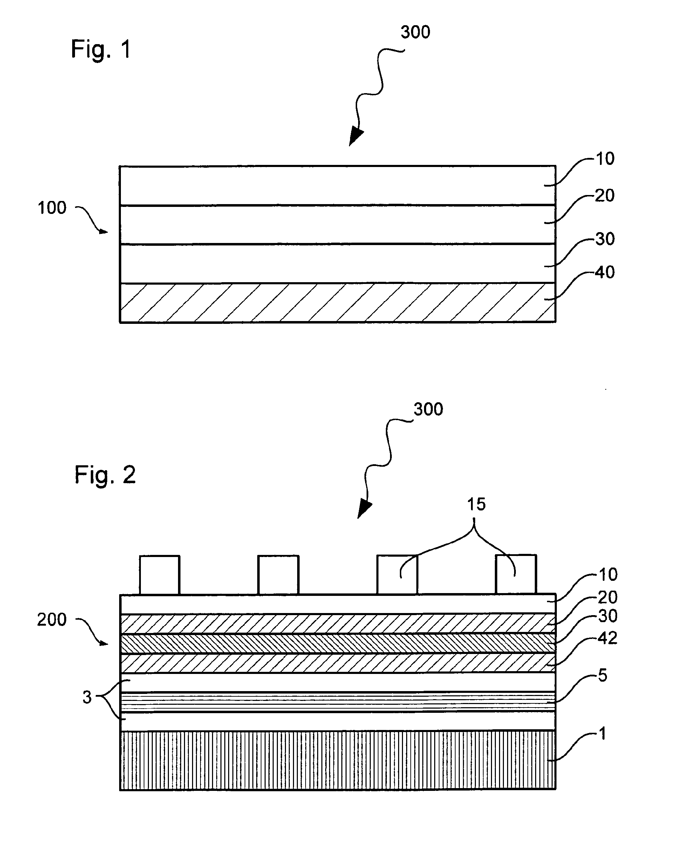

While the basic construction of the photovoltaic device according to the present invention comprises a first electrode, a first and a second semiconductor layer and a second transparent electrode as recited in Claim 1, there may be layers in addition to these layers, as long as the function of the photovoltaic device is not adversely affected by the presence of these additional layers. The basic construction of such a photovoltaic device is shown in Fig. 1. As will be appreciated, the light comes from the side of the second transparent electrode, which is preferably in the form of a layer. In this specification, the "first" and "second" etc. layers are denoted as such in accordance with the order seen from the direction of the incoming light.

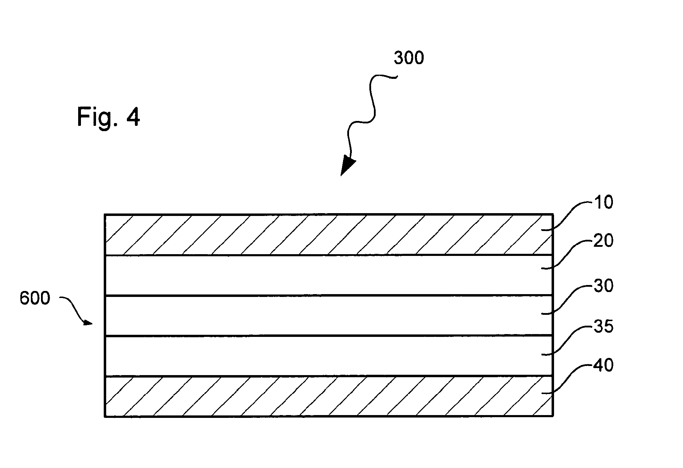

For instance, the photovoltaic device may comprise a third semiconductor layer. In such a three-layered semiconductor structure, the first semiconductor material is preferably n-doped Si, the second semiconductor material is preferably p-doped Si, and the third semiconductor material, i.e. the material in the third semiconductor layer is preferably p⁺-doped Si. Such an embodiment of the photovoltaic device of the present invention is shown in Fig. 4.

As will explained in further detail below, dependent on whether the photovoltaic device is applied, e.g. by printing, on a transparent or non-transparent substrate, the order of applying the respective layers may be reversed.

According to a preferred embodiment, the first and the second semiconductor layers each independently have a layer thickness in the range of 0.4-40 µm, preferably 0.4-20 µm, more preferably 4-20 µm and most preferably 6-15 µm. For the purpose of this invention, the layer thickness, which refers in the case of coating or printing the respective layer to the dry coating thickness thereof, i.e. following the drying step, is preferably determined using a field emission electron microscope, such as FE-REM of Zeiss, Germany, which is equipped with a "Gemini" column.

In order to obtain such layer thickness, the screen printing method using a mixture comprising the particles of the first and the second semiconductor material proved to be particularly advantageous. For instance, a photovoltaic device having a layer thickness of the first and the second semiconductor layers, and an average grain size of the first and second semiconductor materials present within these layers, within the µm ranges as mentioned above seems to show particularly high efficiency. Without being bound by theory, it is presumed that this is due to the optimal match of the grain sizes and layer thickness, which can lead to the formation of heterojunctions between the particles of the first and second semiconductor material, which will at the same time provide a path for the electron-hole pairs to reach the electrodes.

As will be appreciated, a large contact area between the particles of the first semiconductor material and the particles of the second semiconductor material is beneficial when the above reason for the excellent efficiency of the photovoltaic device according to the present invention is assumed. To obtain a large contact area, a small difference between the average grain size of the particles of the first and the second semiconductor material proved beneficial, such as ≤ 6 µm, preferably ≤ 4 µm.

The method of manufacturing the photovoltaic device of the present invention comprises applying at least the semiconductor layers, preferably also the first electrode layer and the second transparent electrode layer and, if present, the insulating layer(s) and the heating layer by printing, spray coating or spin coating. Suitable printing techniques for use in the present invention are without limitation ink jet printing and screen printing, preferably screen printing. These methods, in particular screen printing proved to be particularly suitable for applying layers of the required thickness, such as in the range of 0.4 to 40 µm, preferably 0.4-20 µm.

The printing methods can be carried out batchwise. In this case, metal or plastic films are subjected to the printing. The size of these substrates is typically from 5 cm x 5 cm up to 2 m x 3 m. According to preferred embodiments, the size is 50 cm x 50 cm, 1 m x 1 m or 1 m x 2 m.

In the method of manufacturing photovoltaic devices in accordance with the present invention, mixtures comprising the particles of the respective layer, a binder and a solvent can be applied upon printing. Owing to the viscosity, the above mixture can also be referred to as a paste, and is oftentimes called "printing paste" in this specification. The binder and the solvent may serve to avoid oxidation and contamination of the particles, which may be particles of semiconductor material (in the case of the semiconductor layers), particles of conducting materials (in the case of the electrodes or electrode layers), or particles of insulating materials (in the case of insulating layers).

Suitable binders for use in the manufacturing method of the invention are not specifically limited in kind. Examples of binders include acrylic monomers (both as monofunctional diluents and multifunctional reactive agents), acrylic resins (e.g. acrylic polyol, amine synergists, epoxy acrylics, polyester acrylics, polyether acrylics, styrene/acrylics, urethane acrylics, or vinyl acrylics), alkyd resins (e.g. long-oil, medium-oil, short-oil, or tall oil), adhesion promoters such as polyvinyl pyrrolidone (PVP), amide resins, amino resins (such as melamine-based or urea-based compounds), asphalt/bitumen, butadiene acrylonitriles, cellulosic resins (such as cellulose acetate butyrate (CAB)), cellulose acetate proprionate (CAP), ethyl cellulose (EC), nitrocellulose (NC), or organic cellulose ester), chlorinated rubber, dimer fatty acids, epoxy resin (e.g. acrylates, bisphenol A-based resins, epoxy UV curing resins, esters, phenol and cresol (Novolacs), or phenoxy-based compounds), ethylene co-terpolymers such as ethylene acrylic/methacrylic Acid, E/AA, E/M/AA or ethylene vinyl acetate (EVA), fluoropolymers, gelatin (e.g. Pluronic F-68), glycol monomers, hydrocarbon resins (e.g. aliphatic, aromatic, or coumarone-based such as indene), maelic resins, modified urea, natural rubber, natural resins and gums, rosins, modified phenolic resins, resols, polyamide, polybutadienes (liquid hydroxyl-terminated), polyesters (both saturated and unsaturated), polyolefins, polyurethane (PU) isocyanates (e.g. hexamethylene diisocyanate (HDI), isophorone diisocyanate (IPDI), cycloaliphatics, diphenylmethane diisocyanate (MDI), toluene diisocyanate (TDI), or trimethylhexamethylene diisocyanate (TMDI)), polyurethane (PU) polyols (e.g. caprolactone, dimer-based polyesters, polyester, or polyether), polyurethane (PU) dispersions (PUDs) such as those based on polyesters or polyethers, polyurethane prepolymers (e.g. caprolactone, dimer-based polyesters, polyesters, polyethers, and compounds based on urethane acrylate), Polyurethane thermoplastics (TPU) such as polyester or polyether, silicates (e.g. alkyl-silicates or water-glass based compounds), silicones (amine functional, epoxy functional, ethoxy functional, hydroxyl functional, methoxy functional, silanol functional, or cinyl functional), styrenes, (e.g. styrene-butadiene emulsions, and styrene/vinyl toluene polymers and copolymers), or vinyl compounds (e.g. polyolefins and polyolefin derivatives, polystyrene and styrene copolymers, or polyvinyl acetate (PVAC)).

A second list of suitable binders that can be provided independently from the above examples comprises the following exemplary compounds that can be used with preference as binders: carrageenanes, polyurethane-based thickeners (e.g. Borchigel L75 of Borchers), polysaccharides, polyacrylates, polyvinylpyrrolidone, polyethylene oxide, agar-agar, gum-arabic, alginate, pectines, guar-gum, locust bean gum, starch, dextrins, gelatine, casein, carboxymethylcellulose, cellulose ethers, hydroxyethylcellulose, hydroxypropylcellulose, polyvinylacetate, polystyrene, polycarbonate, polyester, polyvinylalcohol, and polyamides.

When printing several layers on top of each other, the binder used in the printing paste is preferably the same, in order to avoid any incompatibility of the binder.

The printing paste also comprises a solvent that is not particularly limited in kind. As used herein, the solvent may be an aqueous solvent including water. For instance, the solvent can be dipropylenglycol monomethyl ether. As will be appreciated, the binders within the printing paste will enhance, and the solvent will reduce the viscosity of the printing paste. Consequently, the viscosity or rheological properties of the printing paste can be adjusted by way of the weight ratio of binders and solvent within the mixture, i.e. printing paste.

Upon printing, it is desirable to form homogeneous layers comprising particles, e.g. to avoid the formation of holes and pores. While suitable dilution of the printing paste, for instance by adding solvent(s) is possible to achieve this, it proved beneficial to apply vibration. While the frequency of the vibration is not specifically limited, ranges of 10 Hz to 1 MHz, preferably 1 kHz to 100 kHz proved to be advantageous. In practice, the vibration can be generated by a suitable means for vibration (such as available from the company B-Tech of Heilbronn, Germany) within the printing machine.

When applying layers by way of printing, there is preferably a drying step in between the application of two adjacent layers. For instance, a layer can be applied by screen printing, then a drying step is carried out, and subsequently the next layer is applied by screen printing. The drying temperature in the drying step is not particularly limited as long as it is high enough to remove the solvent that is contained in the printing paste. However, the drying temperature is preferably in the range of 60-200°C, more preferably 100-160°C. The drying of the applied layer can be carried out in a flow of hot air, by infrared (IR)-heating, contact heating or microwave heating. As regards the drying atmosphere, air or an inert gas (such as nitrogen or argon) can be exemplified.

After all layers of the photovoltaic device have been applied, including the application of layers by printing, in particular screen printing, the photovoltaic device is baked in a furnace at temperatures in the range of 80 to 800°C. As will be appreciated, the baking temperature is dependent on the materials used in the photovoltaic device. Also, it will be appreciated that the baking step can be carried out in place of the drying step after applying the uppermost layer of the photovoltaic device.

As an alternative to the batch mode of carrying out the printing methods, in particular screen printing methods of the present invention, there is the semi-batch mode. In this case, sections of the support film having e.g. lengths of 2 cm to 300 cm are printed and after rewinding subjected to the drying step. The overall length of the support film is 1 m to 2,000 m.

Finally, the printing, in particular the screen printing method according to the present invention can be carried out continuously using a cylinder screen printing unit.

Upon screen printing the insulating, semiconductive or conductive layers, it proved beneficial to use printing screens made of plastics in order to avoid a contamination of the layers with traces of metals, in particular Fe (iron). This is because traces of metals may act as dopants for the layers, which may adversely affect the performance of the photovoltaic device.

The methods of preparing particles of semiconductor material for use in the photovoltaic device according to the present invention will be illustrated below. Generally, the conductor, semiconductor and insulating materials for use in the present invention are commercially available as granulate material having average grain sizes in the range of mm, such as 1 to 12 mm. In addition, to ensure high photovoltaic performance, highly pure semiconductor materials are generally used. For instance, the purity of the semiconductor materials is at least 5 N, i.e., 99.999%.

To reduce the average grain size down to the range of µm, such as e.g. the range of 0.1 to 20 µm of the semiconductor material, ball mills, toothed-ring dispersers, dissolvers, mortar grinders, cavitation mills or swing mills, or a comminution by way of ultrasound are employed.

Preferably, devices having non-metallic surfaces are used with the purpose of avoiding any contamination of the materials with traces of metals, in particular iron, for the reasons given above. Preferably, the surfaces consist of hard ceramics, such as zirconia ceramics, or of natural minerals, such as agate.

The comminution of particles can be carried out in the dry as well as the wet state. In the case of wet comminution, with the purpose of avoiding contamination with metallic impurities, for instance distilled, preferably ultrapure water, or 1,2-propanediol of similar purity may be used as a "slurrying agent" for forming the slurry to be treated in the comminution devices. Subsequent to wet comminution, the comminution slurry may be dried, e.g. in a vacuum drying furnace, for instance at a temperature of above 30°C, preferably above 40°C.

The comminuted powders are subsequently mixed with the binder and solvent to give a mixture that can be applied in printing in accordance with the manufacturing method of the invention. The pigments may have a limited shelf life in air. To deal with this situation, the pigments can be stored in a suitable storage liquid that is compatible with the further ingredients of the mixture, i.e. printing paste, prior to use. 1,2-propanediol was found to be a suitable storage liquid. 1,2-propanediol has also the capability of reducing the viscosity of the printing paste.

In a particularly preferred method of comminuting the pigments to the desirable average grain size, the starting granulate materials are comminuted in a wet comminution method using 1,2-propanediol as a slurrying agent, and the slurry obtained in the wet comminution treatment is then mixed with the binder.

In the following, the photovoltaic device of the present invention will be described in more detail by reference to the appending drawings.

For the sake of overview, Fig. 1 provides a sectional view on the basic construction of a photovoltaic device in accordance with the present invention. As is shown in the figure, the photovoltaic device 100 comprises a first transparent electrode 10, a first semiconductor layer 20, a second semiconductor layer 30 and a second electrode 40. As shown in the figure, the first transparent electrode and the second electrode are preferably designed as layers.

The light comes from the direction indicated by the arrow 300. The transparent electrode 10 can be formed of any material, as long as it is transparent to the incident light 300 and is a conducting material. For instance, the electrode layer 10 may comprise ZnO or indium-tin-oxide (occasionally abbreviated as "ITO", herein). In the practice of the present invention, the transparent electrode 10 is preferably a printed layer, in particular a layer that is obtained by printing, especially printing, a printing paste, comprising ZnO or ITO pigments having an average grain size in the range of 0.1-10 µm, preferably 0.1-3 µm. According to a particularly preferred embodiment, the transparent electrode is obtained by screen printing a printing paste comprising pigments of ZnO having an average grain size in the range of 0.1-3 µm in dipropylenglycol monomethyl ether as a solvent. In practice, commercially available materials can be used for applying the transparent electrode by printing, in particular screen printing.

Like the first transparent electrode 10, the first and second semiconductor layers 20 and 30 are preferably provided by printing a printing paste comprising particles of the respective semiconductor material and a binder.

The second electrode 40 is not specifically limited in kind as long as it is electrically conductive. It may or may not be transparent. Preferably it is non-transparent and reflective and can as such act as a back surface reflector of the incident light 300, in particular for longer wavelengths. For instance, the second electrode 40 may be a metal film. Suitable metals are aluminum, copper, stainless steel, titanium and molybdenum, with aluminum and stainless steel being preferred. According to a preferred embodiment, the second electrode 40 is an Al film having a layer thickness of 0.05-0.2 mm. As will be appreciated, the aluminum film to be used with preference as the second electrode 40 is bifunctional in that it is electrically conductive and at the same time can act as a back surface reflector, so as to increase the absorbency of the incident light, especially for longer wavelengths. Like the further layers shown in Fig. 1, the second electrode 40 can be a printed layer, in particular prepared by screen printing. In this case, the layer 40 would have to be printed on a substrate that is not shown in Fig. 1.

Referring to Fig. 2, a concrete embodiment of the photovoltaic device for use in the present invention will be described. The photovoltaic device 200 that is schematically shown in a sectional view in Fig. 2 comprises several layers, some of which are optional.

Reference numeral 1 denotes a substrate that may be transparent or non-transparent. If it is non-transparent, it may be a metal film, examples of which were given above when describing the second electrode 40. If the substrate 1 is made of electrically conductive material, e.g. if it is a metal film, it can act as the second electrode in the photovoltaic device 200. In the alternative or in addition, it can act as a back surface reflector. Also, the substrate 1 can be a plastic film such as for instance polyethylene terephthalate (PET), polymethyl methacrylate (PMMA) or polytetrafluorethylene (PTFE) films, or composite films thereof.

Reference numeral 3 denotes an insulating layer. For instance, the insulating layer 3 can be a printed layer provided by screen printing. In this case, a printing paste comprising non-conductive pigments can be used. Particles of barium titanate can be used with preference. In the practice of the present invention, commercially available printing pastes can be used for providing the insulating layer 3. Examples of such commercially available printing pastes are DuPont Luxprint^{®} 8153 and ORMECON EL 5500. To ensure particularly good isolation, the print can be repeated (with intermediate drying). As will be understood, the layer 3 comprises several sub-layers in this case (not shown in Fig. 2). The insulating layer 3 can be dispensed with, when the substrate 1 acts as an electrode.

The layer 5 in Fig. 2 represents a heating layer. For instance, it can be a resistance heating layer. In practice, the layer 5 can be provided by printing commercially available carbon pastes such as C-100 and C-200 (of the firm Conductive Compounds), preferably by providing a pattern upon printing, i.e. providing conductive paths as desired. The heating layer 5 and the insulating layer 3 on top of it are optional but may be beneficial if the photovoltaic device is intended to be used in regions where snow is common since snow covering the photovoltaic device can be molten away by means of the heating layer. Layer 42 is a specific embodiment of the second electrode 40 of Fig. 1. In the embodiment shown in Fig. 2, the layer 42 is preferably a printed layer obtained with a printing paste comprising conductive pigments of Al, Ag, Cu or carbon or mixtures thereof. In the alternative, commercially available materials, such as AG 500, AG 510, C-100, and C-200 (of the firm Conductive Compounds) can be used for printing the second electrode in the present invention. If the substrate 1 is used as an electrode (e.g. it is an Al film) and if there are no layers 3 or 5, the layer 42 can be absent. In this case, the construction of the photovoltaic device resembles the basic construction shown in Fig. 1

As regards the description of the first transparent electrode layer 10, as well as the first and second semiconductor layers 20 and 30, reference can be made to the above description of Fig. 1. For enhancing the electrical conductivity of the upper electrode layer 10, additional electrodes 15 can be provided. As can be seen from Fig. 2, conductive paths 15 can be provided. As will be appreciated, to reduce shadowing, the area occupied by the additional electrodes 15 should preferably be as small as possible. For instance, the conductive paths are applied by patterned printing, in particular screen printing, printing pastes comprising pigments of Al, Ag, Cu or carbon. By printing the additional electrodes, several photovoltaic devices can be electrically connected in series to provide a photovoltaic panel.

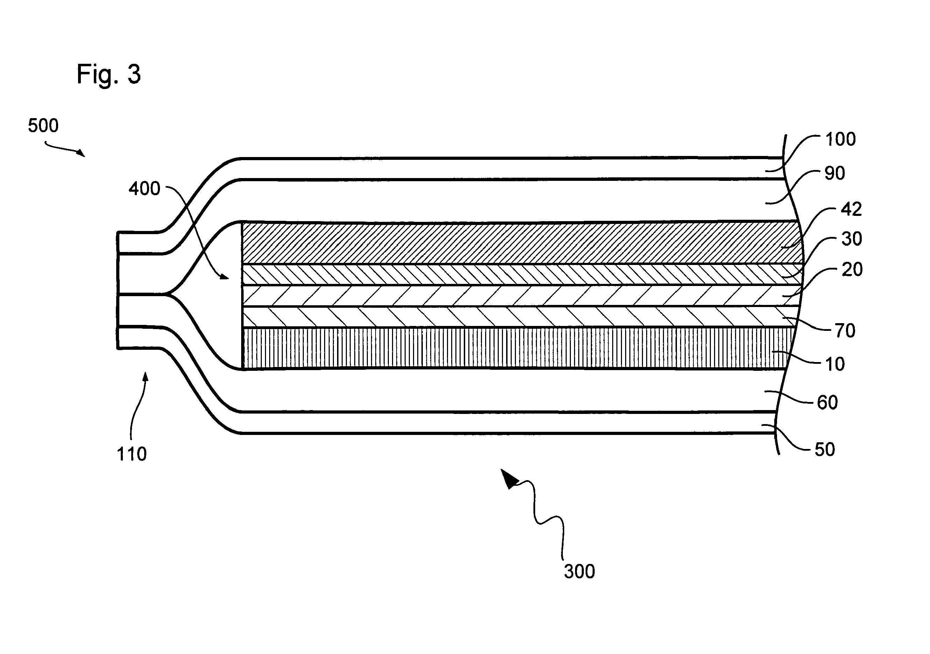

The photovoltaic device according to the invention can be protected against environmental conditions by appropriate sealing. Fig. 3 shows an embodiment of such a sealed photovoltaic device 500. Here, a specific embodiment of the photovoltaic device 400 is sealed by laminating this within films, which are transparent at least on the side of the impinging light 300. In the embodiment shown in Fig. 3, the layers of the photovoltaic device 400 are provided, preferably printed by screen printing, on a support. In Fig. 3, a laminate of plastic films 50 and 60 is used as the support. As will be appreciated, owing to the light direction 300, the composite plastic films 50 and 60 must be transparent. Examples of suitable materials are PET, PMMA or PTFE. Following the application of the layers constituting the photovoltaic device 400, one or more protective layers may be provided. In the sealed photovoltaic device shown in Fig. 3, a composite of two films 90 and 100 is applied. The materials of the films are not specifically limited in kind, as long as they can be bonded, for instance by heat sealing, to the composite films 50/60. In particular, the protective films 90 and 100 must not be transparent. The bonding in the boundary area 110 can for instance be achieved by heat sealing.

To enhance the binding between the support film and the lowermost layer of the photovoltaic device, in the case of Fig. 3 layer 10, the support film is preferably subjected to a suitable surface activation treatment, such as corona treatment or chemical activation. The activation treatment will also enhance the bonding between the protective films and the support films in the boundary area 110 of the sealed photovoltaic device 500. In a particularly preferred embodiment, the sealing in the boundary area 110 is carried out by heat sealing, which is possible when the films coming in contact (layers 90 and 60 in Fig. 3) are heat sealable. The heat sealing can for instance be carried out by heated rollers.

As will be appreciated, the film 100 can also be a metal film, which forms a composite together with the preferably heat sealable plastic film 90. As regards the layers of the photovoltaic device 400, the first transparent electrode layer 10, and the first and second semiconductor layer 20 and 30 have already been described above in connection with Fig. 1. The reference numeral 70 denotes an optional further reinforcing conductive layer, which may be formed by patterned printing of conductive materials, such as Al, Ag, Cu or carbon. The properties of the conductive layer 42 acting as a back electrode in the photovoltaic device 400 have been described in some more detail, above.

Fig. 4 shows a particularly preferred embodiment of a photovoltaic device 600 in accordance with the present invention. In connection with the first transparent electrode layer 10 and the second electrode layer 40, reference can be made to the above description of Fig. 1. The embodiment of the photovoltaic device as shown in Fig. 4 comprises, in addition to the first semiconductor layer 20 and the second semiconductor layer 30, a third semiconductor layer 35. In a modified version of this embodiment, there may be further semiconductor layers, for instance based on Si with different doping. According to a particularly preferred embodiment, the first semiconductor layer 20 comprises n-doped Si particles, the second semiconductor layer 30 comprises p-doped Si particles, and the third semiconductor layer 35 comprises p⁺-doped, i.e. heavily p-doped, Si particles. Thereby, the respective particles in the respective semiconductor layers each have an average grain size in the range of 0.1-20 µm, preferably 1-10 µm. According to a preferred embodiment, the n-doped Si particles contain the dopant, which is preferably phosphorus, in a concentration of 10 ppb-1,000 ppb, preferably of about 100 ppb, the p-doped Si particles contain the dopant, which is preferably boron, in a concentration of 100 ppb-10 ppm, preferably of about 1 ppm, and the p⁺-doped Si particles contain the dopant, which is preferably boron, in a concentration of 10 ppm-1,000 ppm, preferably of about 100 ppm.

The layout of the photovoltaic device can be such that a part thereof is designed as a connecting line (so-called pigtail). The connecting line may be provided with a connecting plug having a pin-and-socket connector. For this purpose, a crimp-connector is used with preference. As pin-and-socket connectors, TYCO or MULTICONTACT may be used. In a different embodiment, the connecting plug is contacted via a solder connection.

Cell breakage or shadowing could cause the photovoltaic device or photovoltaic panel to operate in reverse, forming a so-called "hot spot" with temperatures up to 400°C. This unwanted effect can be avoided in the present invention by applying a so-called bypass diode in parallel to the photovoltaic device or panel but in opposite polarity. According to a preferred embodiment, the bypass diode is connected to the photovoltaic device or panel by means of a crimp connection.

According to a specific aspect, the present invention relates to a photovoltaic panel comprising two or more such as 2-100, preferably 8-20 photovoltaic devices in accordance with the present invention that are connected in series.

Turning to the use of a mixture comprising binder, solvent and semiconductor particles having a grain size in the range of 1-10 µm in the manufacture of photovoltaic devices, the semiconductor particles can be any of the types mentioned in the preceding description. According to a preferred embodiment, the semiconductor particles comprised in the mixture comprise at least two types of differently doped ZnS particles, the dopant preferably being selected from the group of Cu, Mn, Ag and In. According to a particularly preferred embodiment, the semiconductor particles comprised in the mixture for use in the manufacture of photovoltaic devices are Mn-doped ZnS and Cu-doped ZnS particles.

The present invention is further illustrated below by way of preferred embodiments, which however must not be construed in a limiting sense.

### PREFERRED EMBODIMENTS

### Embodiment 1

In connection with the photovoltaic device according to Embodiment 1, reference will be made to Fig. 2. An aluminum film 1 composed of an aluminum alloy comprising > 99% Al, having a thickness of 0.05-0.2 mm, preferably about 0.1 mm and a width of 20-2,000 mm, preferably 500-1,000 mm is used as a substrate. In the alternative, a stainless steel film or sheet having the above dimensions may be used.

On top of this, a printing paste comprising barium titanate pigments is applied by screen printing using a sieve of 80-320 mesh, preferably 200 mesh to provide an insulating layer 3. The obtained layer is dried at 120-140°C for 1-5 min or 10-30 min. The layer thickness after drying was 10-30 µm. In the alternative, the following commercially available products can be used for the insulating layer: DuPont Luxprint^{®} 8153 and ORMECON EL 550. When using these materials, the printing, preferably screen printing is carried out in accordance with the processing specification for these materials. To enhance the electrical insulation, the printing can be carried out twice. If the aluminum film 1 is used as an electrode, the insulating layer 3 is not needed.

As the next step, the second electrode acting as a back electrode 42 is applied by screen printing using a printing paste comprising conductive Ag pigments. In the alternative, pigments of Cu or carbon can be used. The printing is carried out using a screen of 60-320 mesh, preferably 80 mesh. Then, the layer is dried at 120-140°C for 1-5 min or 10-30 min. The back electrode 42 is not needed when the aluminum film 1 is used as the electrode.

Then, the second semiconductor layer, i.e. active layer 30 is printed using a paste comprising CuInGaSe₂ pigments. The purity of the material is at least 5 N, i.e. 99.999%. The pigments have an average grain size of 0.1-10 µm, preferably 3-8 µm. The printing was carried out using a screen of 80-320 mesh, preferably 200 mesh. The printed layer 30 is dried at 80-800°C, preferably at about 680°C. The layer thickness was 3-30 µm, preferably 5-10 µm.

Next, a first semiconductor layer 20 was applied by printing a printing paste comprising pigments of doped ZnS. The purity of the undoped ZnS was at least 5 N, i.e. 99.999%. The ZnS was doped with either Cu or Mn, or with Ag. The concentration of copper as a dopant was 0-10,000 ppm, preferably 600 ppm, the concentration of Mn was 0-10,000 ppm, preferably 8,000 ppm, and the concentration of Ag was 0-10,000 ppm, preferably < 10 ppm, such as 100 ppb-10 ppm. The pigments have an average grain size of 0.1-10 µm, preferably 1-7 µm. The layer is dried at 80-800°C, preferably at 120-140°C. The layer thickness after drying was 3-30 µm, preferably 5-10 µm. The printing paste was applied using a screen of 80-320 mesh, preferably 200 mesh. The layer is dried at 120-140°C. In the alternative, commercial products such as KB500, KB509, KB302 and KB513 of the firm KIM can be used and printed in accordance with the processing specifications thereof.

In this specification, the concentration of dopants is determined by way of electron spectroscopy for chemical application (ESCA), also known as X-ray photoelectron spectroscopy (XPS). For instance, a Fischerscope X-Ray System HDAL of Fischer, Germany can be used.

As the first transparent electrode 10, a transparent printing paste comprising conductive pigments of ZnO is applied by screen printing. The pigments have a particle size of 0.1-10 µm, preferably 0.1-3 µm. In the alternative, ITO could be used. Then, the layer was dried at 80-120°C. The resultant layer thickness was 1-10 µm, preferably 3-5 µm. In the alternative, the commercial product KB-Mode 477 of the firm KIM can be used and applied in accordance with the instructions for use.

The electrical conductivity of the upper electrode 10 can be further enhanced by patterned printing of a further printing paste comprising pigments of Ag and, in the alternative, pigments of Cu or carbon. The printing paste is printed using a screen of 60-320 mesh, preferably 80 mesh. The layer is dried at 80-120°C. The additional electrodes 15 can also be applied by using commercial products such as ESL 9987, ESL 9926 and ORMECON EL 5800.

### Embodiment 2

In the following, the second preferred embodiment will be described. A photovoltaic device was manufactured like in Embodiment 1, except that the aluminum film used as the substrate was slightly thicker and had a thickness of 0.1-3 mm. Again, reference can be made to Fig. 2 for the following description of Embodiment 2. On top of the substrate 1, an insulating layer 3 and a second electrode, namely a back electrode 42 was provided by screen printing as in Example 1.

Different from Example 1, the second semiconductor layer 30, i.e. active layer, was applied by printing a printing paste comprising CdTe particles. The purity of the semiconductor material was at least 5 N, i.e. 99.999%. The pigments were doped with Cl, wherein the concentration of Cl was up to 10,000 ppm, preferably between 100 ppb and 10,000 ppm. The CdTe pigments had an average grain size of 0.1-20 µm, preferably of 6-9 µm or of 14-18 µm. The layer was dried at 80-800°C, preferably at about 680°C. The layer thickness after drying was 5-30 µm, preferably 10-20 µm.

On top of the second semiconductor layer, a first semiconductor layer 20 was provided by screen printing using a printing paste comprising doped CdS particles. The purity of the undoped CdS was at least 5 N, i.e. 99.999%. The CdS was doped with one of the following: (i) Cu and Mn; (ii) An, or (iii) In. The concentration of Cu was 0-10,000 ppm, preferably < 10 pmm, such as 100 ppb-10 ppm. The concentration of Mn and Ag was in the same ranges. The concentration of In was 0-10,000 ppm, preferably about 500 ppm. The CdS particles have an average grain size of 0.1-10 µm, preferably 1-7 µm. The layer 20 is dried at 80-800°C, preferably at 120-140°C. The layer thickness was 3-30 µm, preferably 5-10 µm. Upon screen printing, a screen of 80-240 mesh, preferably 200 mesh was used, and the layer was dried at 120-140°C. The first transparent electrode 10 and additional electrodes 15 were like in Example 1.

## Claims

1. A photovoltaic device comprising a first transparent electrode, a first semiconductor layer comprising particles of a first semiconductor material, a second semiconductor layer comprising particles of a second semiconductor material, and a second electrode, wherein the first and the second semiconductor material are different materials, and wherein the particles of the first and the second semiconductor material have an average grain size in the range of 0.1-20 µm, preferably 1-10 µm.

2. The photovoltaic device according to Claim 1, wherein the first semiconductor material is a doped material selected from the group consisting of ZnS, CdS, ZnO or Y₂O₃, the dopant being preferably selected from the group consisting of Cu, Mn, Ag and In.

3. The photovoltaic device according to Claim 1, wherein the second semiconductor material is selected from the group consisting of CuInGaSe₂, CuInSe₂, GaAs, CdTe, indium gallium nitride and silicon.

4. The photovoltaic device according to any one of Claims 1 to 3, wherein the first and the second semiconductor layers each independently have a layer thickness in the range of 0.4 - 40 µm, preferably 4 - 20 µm, more preferably 6 - 15 µm.

5. The photovoltaic device according to any one of Claims 1 to 4, wherein the difference between the average grain size of the particles of the first and the second semiconductor material is ≤ 6 µm, preferably ≤ 4 µm.

6. The photovoltaic device according to any one of Claims 1 to 5,
wherein the first semiconductor layer has a thickness of 3 - 30 µm, preferably of 5 - 10 µm, and comprises particles of ZnS as a first semiconductor material, the ZnS particles being either doped with Cu and Mn, or with Ag, and having an average grain size in the range of 0.1 to 10 µm, preferably 1 to 7 µm; and
wherein the second semiconductor layer has a thickness of 3 - 30 µm, preferably of 5 - 10 µm, and comprises particles of CuInGaSe₂ as the second semiconductor material, the CuInGaSe₂ particles having an average grain size in the range of 0.1 to 10 µm, preferably 3 to 8 µm.

7. The photovoltaic device according to any one of Claims 1 to 5,
wherein the first semiconductor layer has a thickness of 3 - 30 µm, preferably of 5 - 10 µm, and comprises particles of CdS as the first semiconductor material, the CdS particles being doped with Cu and Mn, or with Ag, or with In, and having an average grain size in the range of 0.1-10 µm, preferably 1-7 µm; and
wherein the second semiconductor layer has a thickness of 5 - 30 µm, preferably of 10 - 20 µm, and comprises particles of CdTe as a second semiconductor material, the CdTe particles being doped with Cl, and having an average grain size in the range of 0.1 - 20 µm, preferably of 3 - 5 µm, 6 - 9 µm or 14 - 18 µm.

8. The photovoltaic device according to any one of Claims 1 to 7, wherein the first transparent electrode is in the form of a layer having a thickness of 1-10 µm, and comprises particles of ZnO or indium tin oxide having a grain size of 0.1 - 10 µm, preferably of 0.1 - 3 µm.

9. The photovoltaic device according to Claim 1, wherein the first semiconductor material is n-doped Si and the second semiconductor material is p-doped Si, and which further comprises a third semiconductor layer comprising particles of p⁺-doped Si, preferably having an average grain size in the range of 0.1-20 µm, more preferably 1-10 µm.

10. A method of manufacturing the photovoltaic device according to any one of Claims 1 to 9, comprising applying at least the semiconductor layers, preferably all layers by printing, spray coating or spin coating, preferably by screen printing.

11. The method according to Claim 10, wherein a mixture comprising the particles and a binder in a solvent is applied.

12. The method according to Claim 10 or 11, wherein the application of a layer is followed by a drying step.

13. The method according to any one of Claims 10 to 12, wherein vibration is applied during printing or coating.

14. The photovoltaic device according to any one of Claims 1 to 9 that is obtainable by a method as recited in any one of Claims 10 to 13.

15. A photovoltaic panel comprising two or more photovoltaic devices according to any one of Claims 1 to 9, or Claim 14 that are connected in series.

16. A use of a mixture comprising a binder, a solvent and semiconductor particles having a grain size in the range of 1 to 10 µm, in the manufacture of photovoltaic devices.
